## Europäisches Patentamt

## European Patent Office

## Office européen des brevets

(19)

(11) Veröffentlichungsnummer: **0 055 804**
**B1**

(12) **EUROPÄISCHE PATENTSCHRIFT**

(45) Veröffentlichungstag der Patentschrift:
27.08.86

(51) Int. Cl.⁴: **H 01 B 12/00**

(21) Anmeldenummer: **81108640.4**

(22) Anmeldetag: **21.10.81**

(54) Kabelförmiger, stabilisierter Supraleiter für Wechselfelder.

(30) Priorität: **22.12.80 DE 3048418**

(43) Veröffentlichungstag der Anmeldung:
**14.07.82 Patentblatt 82/28**

(45) Bekanntmachung des Hinweises auf die Patenterteilung:
**27.08.86 Patentblatt 86/35**

(84) Benannte Vertragsstaaten:
**CH FR GB LI**

(56) Entgegenhaltungen:
**EP - A - 0 004 009**
**EP - A - 0 042 549**
**CH - A - 467 504**
**CH - A - 616 775**
**DE - A - 2 626 914**
**DE - B - 1 564 701**
**DE - B - 1 917 084**
**DE - B - 2 856 885**

(73) Patentinhaber: **Siemens Aktiengesellschaft Berlin und München, Wittelsbacherplatz 2, D-8000 München 2 (DE)**

(72) Erfinder: **Ries, Günter, Dr., Burgunderweg 17, D-7504 Weingarten (DE)**

## Beschreibung

Die Erfindung bezieht sich auf einen kabelförmigen, kryogen stabilisierten Supraleiter für hohe Ströme und Wechselfeldbelastungen.

In der EP-A-42 549, deren Inhalt gemäss Artikel 54 (3) zum Stand der Technik gehört, ist schon ein Supraleiter beschrieben, mit mehreren supraleitenden Elementen, die in ein Matrixmaterial vorbestimmter elektrischer Leitfähigkeit eingebettete Leiteradern aus supraleitendem Material enthalten, und mit mehreren parallel zu ihnen verlaufenden Stabilisierungselementen aus thermisch und elektrisch gut leitendem, bei der Betriebstemperatur des Supraleiters elektrisch normalleitendem Material, dessen elektrische Leitfähigkeit bei der Betriebstemperatur des Hochstromsupraleiters wesentlich grösser als die des Matrixmaterials der supraleitenden Elemente ist, wobei sich in der räumlichen Anordnung jeweils ein supraleitendes Element und ein Stabilisierungselement abwechseln und jedes Stabilisierungselement von den jeweils benachbarten supraleitenden Elementen mit vorbestimmtem Abstand räumlich getrennt auf einem Trägerkörper um diesen verseilt angeordnet ist, derart, dass nur eine mässige ohmsche Kopplung zwischen den verschiedenen Elementen besteht.

Bei diesem Supraleiter ist also eine räumliche Trennung der supraleitenden Elemente von den Stabilisierungselementen vorgesehen. Zwischen diesen parallel angeordneten Elementen ist somit nur eine schlecht wärmeleitende Verbindung vorhanden. Ausserdem besteht zwischen diesen Elementen eine mässige ohmsche Kopplung, die beim Normalleitendwerden eines supraleitenden Elementes einen Übergang des Stromes in das parallel liegende Stabilisierungsmaterial erlaubt. Die normalleitenden Stabilisierungselemente haben dabei einen wesentlich geringeren elektrischen Längswiderstand als die supraleitenden Elemente, wenn diese normalleitend geworden sind, und übernehmen dann wegen der galvanischen Kopplung zwischen diesen Elementen den grössten Teil des im gesamten Hochstromsupraleiter fliessenden Stromes. Die dabei entstehende Stromwärme in den supraleitenden Elementen ist wegen der geringen Leitfähigkeit klein, und die Temperatur sinkt infolge der guten Kühlung von bis zu drei Seiten rasch unter die Sprungtemperatur des Supraleiters. Dabei ist die sich einstellende Temperatur in den normalleitenden Stabilisierungselementen im Gegensatz zu den bekannten Leiterausbildungen nur von geringem Einfluss auf das Erholungsverhalten des Gesamtleiters. Da ausserdem der elektrische Querwiderstand des Hochstromleiters gross ist, sind seine Wechselfeldverluste entsprechend klein. Er kann deshalb insbesondere für Poloidal- und Torusfeldspulen in plasmaphysikalischen Geräten wie z.B. in Fusionsreaktoren verwendet werden.

Bei dem zum Stand der Technik zählenden Supraleiter wird die mässige ohmsche Kopplung zwischen den verschiedenen Elementen, die aufgabengemäss einen verlustarmen Betrieb auch bei Wechselfeldanwendungen gewährleisten soll, ohne auf die kryogene Stabilisierung zu verzichten, dadurch herbeigeführt, dass die mit Zwischenraum benachbarten Elemente auf dem Trägerkörper, der eine relativ geringe elektrische Leitfähigkeit hat, mit einem hoch rezessiven Lot aufgelötet oder aufgeschweisst werden. Auch eine Leiterumhüllung kann zu der geringen Kopplung beitragen. In der vorliegenden Anmeldung soll eine weitere Lösung der schon der EP-A-42 549 zugrundeliegenden o.g. Aufgabe angegeben werden.

Diese Lösung besteht darin, dass die einzelnen supraleitenden Elemente und Stabilisierungselemente hinsichtlich des Weges über den Trägerkörper weitgehend voneinander elektrisch isoliert sind, dass jedoch jedes Stabilisierungselement mit einem der neben ihm liegenden supraleitenden Elemente an einzelnen, in Leiterlängsrichtung hintereinanderliegenden Stellen – beispielsweise durch Stege zwischen den beiden Elementen oder durch gegenseitiges Verlöten – elektrisch leitend verbunden ist und dass die so aus jeweils einem supraleitenden Element und einem Stabilisierungselement gebildeten Teilleiter lediglich nach jeweils einer oder mehreren Verseilschlaglängen durch einen elektrisch gut leitenden Querverbinder untereinander verbunden sind.

Mit der erfindungsgemässen Ausgestaltung des kabelförmigen, kryogen stabilisierten Supraleiters der eingangs genannten Art sind ebenfalls die Vorteile verbunden, die sich für den aus der EP-A-42 549 bekannten Hochstromsupraleiter ergeben.

Zwar ist aus der DE-A-2 626 914 ebenfalls bekannt, bei einem kabelförmigen, kryogen stabilisierten Supraleiter eine mässige ohmsche Kopplung dadurch zu gewährleisten, dass einzelne supraleitende Elemente auf einem Trägerkörper beabstandet angeordnet werden. Jedoch sollen diese Elemente dabei jeweils aus einem Bündel supraleitender Filamente bestehen, die in eine normalleitende Matrix aus Kupfer eingebettet sind. Auch ein darum angeordneter Mantel besteht aus normalleitendem Material wie Kupfer. Alle diese normalleitenden Materialien dienen zur Stabilisierung, d.h., bei dem bekannten supraleitenden Kabel ist das supraleitende Material unmittelbar von stabilisierendem Material umgeben. Ein derartiger Aufbau soll beim Anmeldungsgegenstand aber gerade nicht vorgesehen sein.

Auch das für Wechselfeldbelastungen vorgesehene, aus der CH-A-616 775 bekannte supraleitende Kabel ist aus supraleitenden Elementen und Stabilisierungselementen zusammengesetzt, wobei diese Elemente jeweils von einem Material mit hohem elektrischen Widerstand umgeben sind. Bei diesem Kabel sind jedoch alle diese Elemente über die gesamte Leiterlänge unmittelbar aneinandergefügt, auch Querverbindungen innerhalb der Teilleiter und der Teilleiter untereinander, wie sie gemäss der vorliegenden Erfindung vorgesehen sind, weist das bekannte Kabel nicht auf.

Vorteilhafte Ausgestaltungen des Supraleiters nach der Erfindung gehen aus den abhängigen Ansprüchen hervor.

Zur weiteren Erläuterung der Erfindung und deren in den abhängigen Ansprüchen gekennzeichneten Weiterbildungen wird auf die Zeichnung Bezug genommen, in deren Figuren 1 und 2 ein Einzelleiter bzw. ein mit solchen Einzelleitern aufgebautes supraleitendes Element eines Supraleiters nach der Erfindung dargestellt sind. Die Figuren 3 bis 5 zeigen zwei Ausführungsbeispiele von Teilleitern des Supraleiters mit einem derartigen supraleitenden Element, während in den Figuren 6 und 7 der mit solchen Teilleitern aufgebaute gesamte Supraleiter nach der Erfindung veranschaulicht ist.

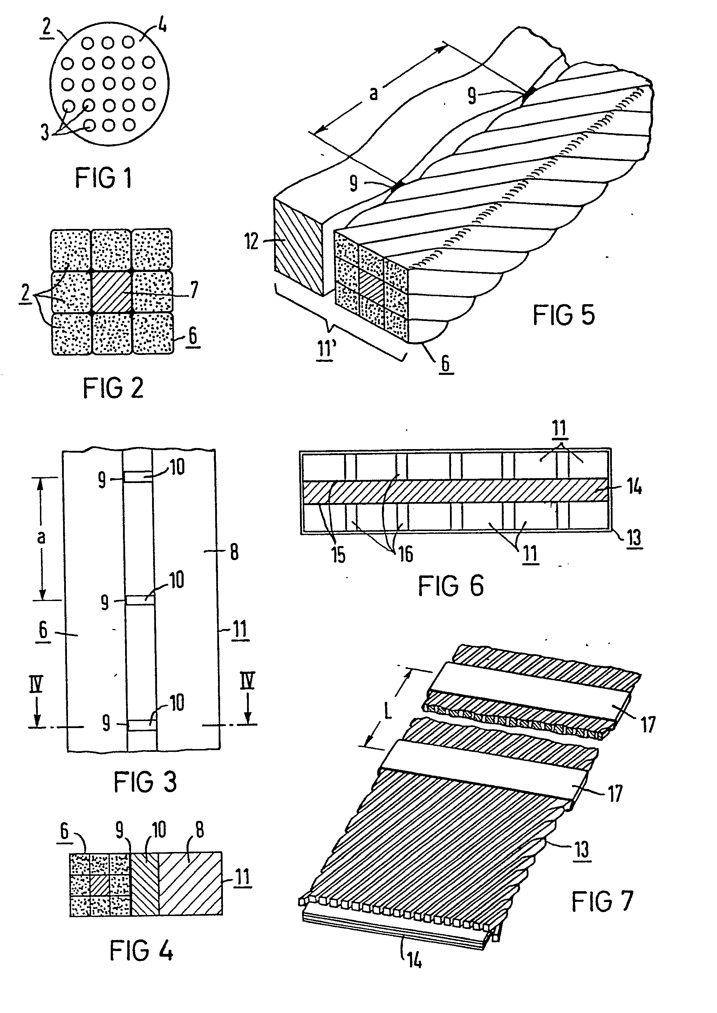

Der in Fig. 1 in einem Querschnitt schematisch dargestellte, allgemein mit 2 bezeichnete Einzelleiter enthält eine Vielzahl von supraleitenden Leiteradern 3, die in bekannter Weise getwistet, d.h. miteinander verdrillt und in eine Matrix 4 eingebettet sind. Als Matrixmaterial wird ein Material verwendet, dessen elektrische Leitfähigkeit bei der Betriebstemperatur des Supraleiters wesentlich kleiner als die von Kupfer oder Aluminium ist. Vorteilhaft ist sie mindestens eine 10er Potenz kleiner. Entsprechende Materialien können insbesondere Legierungen des Kupfers oder des Aluminiums sein. Als supraleitende Einzelleiter 2 lassen sich z.B. in eine Kupfer-Zinn-Bronze-matrix eingebettete $Nb_3Sn$-Filamente oder in eine Kupfer-Nickel-Legierungsmatrix eingebettete Nb-Ti-Filamente verwenden. Die Einzelleiter können aber auch Bündel von mit Niobcarbonitrid beschichteten Kohlenstoffasern in entsprechenden Matrizen sein. Der in der Figur dargestellte Einzelleiter 2 hat eine etwa runde Querschnittsform. Jedoch können auch entsprechende Einzelleiter mit anderen, beispielsweise rechteckigen Querschnittsformen vorgesehen werden.

Zur Herstellung des Supraleiters nach der Erfindung werden mehrere der Einzelleiter 2 gemäss Fig. 1 zu einem Bündelleiterelement zusammengefasst. Entsprechend dem in Fig. 2 schematisch angedeuteten Querschnitt eines solchen mit 6 bezeichneten Bündelleiterelementes sind acht Einzelleiter 2 um einen Kern 7 aus einem isolierenden oder schlecht leitenden Material wie z.B. aus dem Material der Matrix 4 verseilt angeordnet. Die Einzelleiter dieses Bündels sind an ihren gemeinsamen Berührungsflächen zu einem kompakten Element miteinander verbunden, beispielsweise mit einem hochresistiven Lot verlötet. Das so erhaltene, allgemein als supraleitendes Element 6 bezeichnete Leiterteil des Supraleiters mit einer Vielzahl von in seinem Matrixmaterial vorbestimmter elektrischer Leitfähigkeit eingebetteter supraleitender Leiteradern ist beispielsweise durch Walzen auf eine vorbestimmte, insbesondere rechteckige Querschnittsform gebracht.

Gemäss der in Fig. 3 schematisch dargestellten Aufsicht ist parallel zu dem supraleitenden Element 6 nach Fig. 2 ein Stabilisierungselement 8 angeordnet. Dieses Element 8 besteht aus einem thermisch und elektrisch gut leitenden Material, das bei der Betriebstemperatur des Supraleiters elektrisch normalleitend ist und zur Stabilisierung des supraleitenden Elementes 6 dient. Das z.B.

aus Kupfer oder Aluminium bestehende Stabilisierungselement 8 soll nur an einzelnen, in Längsrichtung des Leiters, d.h. in Stromführungsrichtung gesehen hintereinanderliegenden Stellen 9 mit dem supraleitenden Element 6 elektrisch leitend verbunden sein. Hierzu sind gemäss dem Ausführungsbeispiel nach Fig. 3 einzelne, unter vorbestimmten Abständen a hintereinander angeordnete, quer zur Stromführungsrichtung verlaufende Stege 10 vorgesehen, über die das Stabilisierungselement 8 mit dem benachbarten supraleitenden Element 6 verbunden, beispielsweise verlötet ist. Die Stege 10 können mit dem Stabilisierungselement 8 einen gemeinsamen Formkörper bilden. Ebensogut kann auch ein in Längsrichtung gewelltes oder zickzackförmiges Stabilisierungselement vorgesehen sein, das nur an seinen Ausbuchtungen bzw. Spitzen mit dem supraleitenden Element 6 verbunden wird. In den zwischen den einzelnen Verbindungsstellen 9 liegenden Bereichen ist somit kein direkter elektrischer und thermischer Kontakt zwischen dem Stabilisierungselement 8 und dem supraleitenden Element 6 vorhanden. Der so aus dem supraleitenden Element 6 und dem Stabilisierungselement 8 zusammengesetzte, stabilisierte Teilleiter 11 des Supraleiters nach der Erfindung ist in Fig. 4 als Querschnitt veranschaulicht, wobei die Querschnittsebene durch die in Fig. 3 mit IV–IV bezeichnete Linie gelegt ist.

Gemäss dem Ausführungsbeispiel nach den Fig. 3 und 4 wurde angenommen, dass die Stabilisierungselemente 8 der Teilleiter 11 des Supraleiters durch einzelne, in Leiterlängsrichtung hintereinander angeordnete Querstege 10 mit den jeweils benachbarten supraleitenden Element 6 verbunden sind. Wie jedoch aus der in Fig. 5 dargestellten Schrägansicht eines supraleitenden Teilleiters 11' zu entnehmen ist, können auch in Längsrichtung gewellte oder zickzackförmige Stabilisierungselemente 12 vorgesehen sein, die an ihren dem supraleitenden Element 6 zugewandten Ausbuchtungen bzw. Spitzen mit dem Element 6 elektrisch leitend verbunden, beispielsweise verlötet sind. Die Wellung der Stabilisierungselemente 12 ist dabei so vorgenommen, dass sich zwischen den elektrischen Verbindungsstellen 9 jeweils ein Abstand a ergibt.

Eine zum Erreichen der geforderten Nennstromstärke des Supraleiters nötige Anzahl an stabilisierten Teilleitern gemäss den Figuren 3 bis 5 wird parallel zu einem einlagigen Seil, z.B. zu einem Flachseil, Rundseil oder Röbelstab verarbeitet. Der in den Figuren 6 und 7 als Querschnitt bzw. in Schrägansicht schematisch veranschaulichte, allgemein mit 13 bezeichnete Supraleiter nach der Erfindung ist aus einer Vielzahl solcher Teilleiter 11 oder 11' zu einem Flachseil aufgebaut. Diese Teilleiter sind um einen bandförmigen Trägerkörper 14 verseilt oder verlitzt und gegenseitig isoliert angeordnet. Der Trägerkörper besteht z.B. aus einem unmagnetischen Material hoher mechanischer Festigkeit und verhältnismässig geringer elektrischer und thermischer Leitfähigkeit wie z.B. aus Edelstahl. Er enthält zumindest an seiner Aussenseite ein isolierendes Material; beispielsweise ist er mit einer isolierenden Aussenschicht 15 ummantelt. Die Teilleiter 11 oder 11' sind so mit gegenseitigem Abstand parallel auf diesem Trägerkörper befestigt, dass zwischen jeweils benachbarten Teilleitern ein vorbestimmter Zwischenraum 16 ausgebildet ist. Es wird somit die geforderte elektrische Isolation zwischen benachbarten Teilleitern gewährleistet. Beispielsweise kann der Zwischenraum 16 zumindest zum Teil durch ein elektrisch isolierendes Material wie durch einen Kunststoff ausgefüllt sein. Die Zwischenräume 16 können jedoch auch vollständig frei bleiben und von dem die supraleitenden Teile des Leiters auf ihrer bestimmten Betriebstemperatur haltenden kryogenen Kühlmittel wie z.B. flüssigem Helium ausgefüllt sein.

Gemäss der Erfindung soll eine elektrisch gut leitende Querverbindung zwischen den Teilleitern 11 oder 11' des Supraleiters 13 nach jeweils einer oder mehreren Verseilschlaglängen, d.h. nach jeweils einer oder mehreren Umdrehungen um die Längsachse des Gesamtleiters, hergestellt sein. Entsprechende Querverbinder können z.B. Lötbrücken oder Einspannbacken sein.

Gemäss dem Ausführungsbeispiel nach der Fig. 7 ist angenommen, dass die elektrischen Verbindungsstellen in Leiterlängsrichtung jeweils um einen Abstand L, der eine Verseilschlaglänge beträgt, hintereinander angeordnet sind. Die elektrischen Verbindungen werden z.B. durch Bandagen 17 aus Folienblechen aus einem elektrisch gut leitenden Material wie z.B. Kupfer hergestellt, die um den Leiter gelegt und mit den Teilleitern verlötet werden. Der in Figur 6 dargestellte Querschnitt soll gerade an einer solchen Stelle vorgenommen sein.

Darüber hinaus kann der Supraleiter 13 nach der Erfindung von einer in den Figuren 6 und 7 nicht gezeigten, kühlmitteldichten Hülle aus einem Material hoher Festigkeit wie z.B. Edelstahl umschlossen sein. Es ergibt sich so ein Hohlleiter, der von dem kryogenen Kühlmittel forciert zu durchströmen ist. Hüllen von ähnlich ausgebildeten Supraleitern sind z.B. aus der DE-A-2 626 914 oder der DE-A-2 809 513 zu entnehmen. Neben einer forcierten Kühlung eines derartigen Hohlleiters kann aber auch eine Badkühlung des Supraleiters 13 vorgenommen werden, wobei gegebenenfalls auf derartige Hüllen verzichtet werden kann.

Im folgenden ist ein Ausführungsbeispiel des anhand der Figuren 1 bis 7 erläuterten Supraleiters nach der Erfindung angegeben.

Der Leiter soll 50 kA bei einem Feld von 7 Tesla tragen können. Ausgegangen wird von einem supraleitenden Einzelleiter, der ein Niob-Titan-Multifilamentdraht von 1 mm Durchmesser mit kurzer Twistlänge ist. Als Matrixmaterial dient Kupfer, das auch Integrieren von Nickel oder anderen Materialien auf einen spezifischen elektrischen Widerstand von $2 \times 10^{-9}$ bis $2 \times {}^{-8}$ ω m gebracht wurde. Das Verhältnis von Matrixmaterial zu Supraleitermaterial beträgt dabei etwa 1:1. Acht derartige drahtförmige Einzelleiter werden anschliessend um einen Kupfer-Nickel-Draht oder einen rostfreien Stahldraht verseilt, mit einem hochresistiven Lot verlötet und zu einem Bündelleiterelement mit rechteckiger Gestalt kompaktiert. Das Stabilisierungsmaterial wird in Form von gut leitendem Kupfer mit Rechteckprofil von etwa $3 \times 3$ mm parallel geführt und mit dem supraleitenden Element in kurzen Abständen elektrisch verbunden. Beispielsweise kann das Kupfer gemäss Fig. 5 Zickzackform aufweisen und alle 2 cm mit dem supraleitenden Element verlötet werden. Von diesen stabilisierten Teilleitern werden 25 Stück unter Einhaltung eines gegenseitigen Abstandes um einen bandförmigen Kabelkern mit der Breite von etwa 120 mm verseilt, auf dem vorher eine aushärtbare Glasfaser-Epoxid-Schicht aufgebracht wurde. Derartige Materialien sind unter dem Namen «Prepreg» bekannt. Durch Erwärmen werden dann die Teilleiter mit dem Kern so verklebt, wobei sie elektrisch voneinander isoliert sind. Die elektrische Verbindung wird nach jeweils einer Verseilschlaglänge von beispielsweise 1 m hergestellt durch Auflöten einer Bandage aus einer Kupferfolie von 1 bis 2 cm Breite. Der so hergestellte 50 kA-Leiter wird in der Wicklung entweder durch Eintauchen in flüssiges Helium gekühlt oder nach Einschliessen in eine Leiterhülle durch strömendes Helium.

## Patentansprüche

1. Kabelförmiger, kryogen stabilisierter Supraleiter für hohe Ströme und Wechselfeldbelastungen mit mehreren supraleitenden Elementen (6), die in ein Matrixmaterial (4) vorbestimmter elektrischer Leitfähigkeit eingebettete Leiteradern (3) aus supraleitendem Material enthalten, und mit mehreren parallel zu ihnen verlaufenden Stabilisierungselementen (8; 12) aus thermisch und elektrisch gut leitendem, bei der Betriebstemperatur des Supraleiters elektrisch normalleitendem Material, dessen elektrische Leitfähigkeit bei der Betriebstemperatur wesentlich grösser als die des Matrixmaterials (4) der supraleitenden Elemente (6) ist, wobei sich in der räumlichen Anordnung jeweils ein supraleitendes Element (6) und ein Stabilisierungselement (8; 12) abwechseln und jedes Stabilisierungselement (8; 12) von den jeweils benachbarten supraleitenden Elementen (6) mit vorbestimmtem Abstand räumlich getrennt auf einem Trägerkörper (14) um diesen verseilt angeordnet ist, derart, dass nur eine mässige ohmsche Kopplung zwischen den verschiedenen Elementen besteht, und wobei ferner die einzelnen supraleitenden Elemente (6) und Stabilisierungselemente (8; 12) hinsichtlich des Weges über den Trägerkörper (14) weitgehend voneinander elektrisch isoliert sind, jedoch jedes Stabilisierungselement (8; 12) mit einem der neben ihm liegenden supraleitenden Elemente (6) an einzelnen, in Leiterlängsrichtung hintereinanderliegenden Stellen (9) – beispielsweise durch Stege (10) zwischen den beiden Elementen oder durch gegenseitiges Verlöten – elektrisch leitend verbunden ist und die so aus jeweils einem supraleitenden Element (6) und einem Stabilisierungselement (8; 12) gebildeten Teilleiter (11, 11') lediglich nach jeweils einer oder mehreren Verseilschlaglängen (L) durch einen elektrisch gut leitenden Querverbinder (17) untereinander verbunden sind.

2. Supraleiter nach Anspruch 1, dadurch gekennzeichnet, dass die Teilleiter (11; 11') mittels eines aushärtbaren Klebers auf dem Trägerkörper (14) befestigt sind.

3. Supraleiter nach Anspruch 1 oder 2, dadurch gekennzeichnet, dass der elektrisch gut leitende Querverbinder eine die Teilleiter (11, 11') umschliessende Bandage (17) aus elektrisch gut leitendem Material ist (Fig. 7).

4. Supraleiter nach einem der Ansprüche 1 bis 3, gekennzeichnet durch einen gewellten oder zickzackförmigen Verlauf der Stabilisierungselemente (12) in Längsrichtung (Fig. 5).

5. Supraleiter nach einem der Ansprüche 1 bis 4, dadurch gekennzeichnet, dass die supraleitenden Elemente (6) der Teilleiter (11; 11') mehrere supraleitende Einzelleiter (2) aus in eine Matrix (4) der vorbestimmten elektrischen Leitfähigkeit eingebetteten supraleitenden Leiteradern (3) enthalten.

6. Supraleiter nach Anspruch 5, dadurch gekennzeichnet, dass mehrere um einen Kern (7) aus elektrisch schlecht leitendem Material verseilte Einzelleiter (2) zu dem supraleitenden Element (6) zusammengefasst sind.

7. Supraleiter nach Anspruch 5 oder 6, gekennzeichnet durch ein Matrixmaterial (4) der supraleitenden Einzelleiter (2), dessen elektrische Leitfähigkeit mindestens um eine 10er Potenz kleiner ist als die des normalleitenden Materials der Stabilisierungselemente (8; 12).

8. Supraleiter nach einem der Ansprüche 5 bis 7, gekennzeichnet durch supraleitende Einzelleiter (2) mit einer Matrix (4) aus Kupfer-Zinn-Bronze und supraleitenden Leiteradern (3) aus Nb$_3$Sn.

9. Supraleiter nach einem der Ansprüche 5 bis 7, gekennzeichnet durch supraleitende Einzelleiter (2) mit einer Matrix (4) aus einer Kupfer-Nickel-Legierung und supraleitenden Leiteradern (3) aus einer Nb-Ti-Legierung.

10. Supraleiter nach einem der Ansprüche 5 bis 7, gekennzeichnet durch supraleitende Einzelleiter (2) mit Bündeln von mit Niobcarbonitrid beschichteten Kohlenstoffasern.

11. Supraleiter nach einem der Ansprüche 1 bis 10, gekennzeichnet durch eine kühlmitteldichte Umhüllung aus einem unmagnetischen Material.

**Claims**

1. A cryogenically stabilised superconductor in the form of a cable for high currents and alternating field loads, having a plurality of superconductive elements (6) which contain conductor wires (3) of superconducting material, embedded in a matrix material (4) having a predetermined electrical conductivity, and a plurality of stabilising elements (8; 12) which extend parallel to said superconductive elements and which consist of thermally and electrically highly conductive material which becomes electrically normally conductive at the operating temperature of the superconductor and the electrical conductivity of which at the operating temperature is substantially greater than that of the matrix material (4) of the superconductive elements (6), wherein the arrangement comprises alternating superconductive elements (6) and stabilising elements (8; 12), each stabilising element (8; 12) being arranged on a carrier body (14) being spaced from the adjacent superconductive elements (6) by a predetermined distance on a carrier body (14) around which it is stranded, in such manner that only a moderate ohmic coupling takes place between the various elements, wherein, moreover, the individual superconductive elements (6) and stabilising elements (8; 12) are substantially electrically insulated from one another as regards their passage over the carrier body (14), although each stabilising element (8; 12) is electrically conductively connected to one of the adjacent superconductive elements (6) at individual locations (9) which are arranged in series in the longitudinal direction of the conductor, for example, by means of bridges (10) between the two elements, or by mutual soldering, and wherein the subsidiary conductors (11, 11'), each formed from a superconductive element (6) and a stabilising element (8; 12), are connected to one another by an electrically highly conductive cross-connector (17) only after at least one stranding lay length (L).

2. A superconductor as claimed in Claim 1, characterised in that the subsidiary conductors (11; 11') are secured to the carrier body (14) by means of a hardenable adhesive.

3. A superconductor as claimed in Claim 1 or Claim 2, characterised in that the electrically highly conductive cross-connector is a binding (17) surrounding the subsidiary conductors (11, 11') and consisting of electrically highly conductive material (Fig. 7).

4. A superconductor as claimed in one of Claims 1 to 3, characterised by a corrugated or zig-zag course for the stabilising elements (12) in the longitudinal direction (Fig. 5).

5. A superconductor as claimed in one of Claims 1 to 4, characterised in that the superconductive elements (6) of the subsidiary conductors (11; 11') contain a plurality of superconductive individual conductors (2) consisting of superconductive conductor wires (3) embedded in a matrix (4) which has the predetermined electrical conductivity.

6. A superconductor as claimed in Claim 5, characterised in that a plurality of individual conductors (2), stranded around a core (7) consisting of electrically poorly conductive material are combined to form the superconductive element (6).

7. A superconductor as claimed in Claim 5 or Claim 6, characterised by a matrix material (4) for the superconductive individual conductors (2) the electrical conductivity of which is lower by at least a power of ten than that of the normally conductive material of the stabilising elements (8; 12).

8. A superconductor as claimed in one of Claims 5 to 7, characterised by superconductive individual conductors (2) having a matrix (4) consisting of copper-tin bronze and superconductive conductor wires (3) consisting of Nb₃Sn.

9. A superconductor as claimed in one of Claims 5 to 7, characterised by superconductive individual conductors (2) having a matrix (4) consisting of a copper-nickel alloy and superconductive conductor wires (3) consisting of a Nb-Ti alloy.

10. A superconductor as claimed in one of Claims 5 to 7, characterised by superconductive individual conductors (2) having bundless of carbon fibres coated with niobium carbonitride.

11. A superconductor as claimed in one of Claims 1 to 10, characterised by a casing which is impervious to coolant and which consists of a non-magnetic material.

### Revendications

Supraconducteur en forme de câble, à stabilisation cryogénique, pour courants et charges de champs alternatifs élevés, comprenant plusieurs éléments supraconducteurs (6) qui contiennent des brins de conducteur (3) en matériau supraconducteur, noyés dans un matériau de matrice (4) de conductivité électrique prédéterminée, de même que, parallèlement à eux, plusieurs éléments de stabilisation (8; 12) en matériau bon conducteur thermique et électrique, qui est à conduction électrique normale à la température de service du supraconducteur et dont la conductivité électrique à la température de service est nettement plus élevée que celle du matériau de matrice (4) des éléments supraconducteurs (6), dans lequel la disposition dans l'espace est telle qu'un élément supraconducteur (6) alterne chaque fois avec un élément de stabilisation (8; 12) et chaque élément de stabilisation (8; 12), séparé dans l'espace des éléments supraconducteurs (6) voisins d'une distance prédéterminée, est disposé sur un corps porteur (14) en étant câblé autour de celui-ci, de manière qu'il y ait seulement un couplage ohmique modéré entre les différents éléments, et dans lequel, en outre, les différents éléments supraconducteurs (6) et de stabilisation (8; 12) sont largement isolés électriquement les uns des autres quant au chemin passant par le corps porteur (14), mais chaque élément de stabilisation (8; 12) est relié électriquement à l'un des éléments supraconducteurs (6) disposés à côté de lui à différents endroits (9) situés les uns derrière les autres dans le sens de la longueur du conducteur – par exemple par des entretoises (10) entre les deux éléments ou par leur soudage l'un à l'autre – et les conducteurs partiels (11, 11') ainsi formés chacun d'un élément supraconducteur (6) et d'un élément de stabilisation (8; 12) sont seulement reliés entre eux après chaque pas de câblage (L), ou après chaque fois plusieurs pas de câblage, par une liaison transversale (17) bonne conductrice d'électrique.

2. Supraconducteur selon la revendication 1, caractérisé en ce que les conducteurs partiels (11, 11') sont fixés sur le corps porteur (14) au moyen d'une colle durcissable.

3. Supraconducteur selon la revendication 1 ou 2, caractérisé en ce que la liaison transversale, bonne conductrice d'électrique, est un bandage (17) en matériau bon conducteur électrique entourant les conducteurs partiels (11, 11') (Fig. 7).

4. Supraconducteur selon une des revendications 1 à 3, caractérisé par une forme ondulée ou en zigzag des éléments de stabilisation (12) dans le sens longitudinal (Fig. 5).

5. Supraconducteur selon une des revendications 1 à 4, caractérisé en ce que les éléments supraconducteurs (6) des conducteurs partiels (11, 11') contiennent plusieurs conducteurs élémentaires supraconducteurs (2) formés de brins supraconducteurs (3) noyés dans une matrice (4) de conductivité électrique prédéterminée.

6. Supraconducteur selon la revendication 5, caractérisé en ce que plusieurs conducteurs élémentaires (2) sont câblés autour d'une âme (7) d'un matériau mauvais conducteur électrique pour former l'élément supraconducteur (6).

7. Supraconducteur selon la revendication 5 ou 6, caractérisé par un matériau de matrice (4), des conducteurs élémentaires supraconducteurs (2), dont la conductivité électrique est inférieure d'un facteur 10 au moins à celle du matériau conducteur normal des éléments de stabilisation (8; 12).

8. Supraconducteur selon une des revendications 5 à 7, caractérisé par des conducteurs élémentaires supraconducteurs (2) formés d'une matrice (4) en cuivre-étain-bronze et de brins supraconducteurs (3) en Nb₃SN.

9. Supraconducteur selon une des revendications 5 à 7, caractérisé par des conducteurs élémentaires supraconducteurs (2) formés d'une matrice (4) en alliage de cuivre-nickel et de brins supraconducteurs (3) en alliage Nb-Ti.

10. Supraconducteur selon une des revendications 5 à 7, caractérisé par des conducteurs élémentaires supraconducteurs (2) comprenant des faisceaux de fibres de carbone revêtues de carbonitrure de niobium.

11. Supraconducteur selon une des revendications 1 à 10, caractérisé par une enveloppe étanche au réfrigérant en matériau amagnétique.

FIG 1

FIG 2

FIG 5

FIG 3

FIG 6

FIG 4

FIG 7